# EUROPEAN PATENT SPECIFICATION

(11) **EP 3 130 929 B1**
(45) Date of publication and mention of the grant of the patent: **08.07.2020**
(21) Application number: 15776675.9
(22) Date of filing: 06.04.2015
(51) Int. Cl.: G01R 15/20

(54) **CURRENT DETECTION DEVICE**
STROMERKENNUNGSVORRICHTUNG
DISPOSITIF DE DÉTECTION DE COURANT

(30) Priority: 07.04.2014 JP 2014078367
(43) Date of publication of application: 15.02.2017
(73) Proprietor: Alps Alpine Co., Ltd., Tokyo 145-8501 (JP)
(72) Inventor: KAWASAKI, Hideaki, Tokyo 145-8501 (JP)
(74) Representative: Schmitt-Nilson Schraud Waibel Wohlfrom Patentanwälte Partnerschaft mbB
(86) International application number: PCT/JP2015/060767
(87) International publication number: WO 2015/156260

(56) References cited:
- WO-A1-2013/005458
- JP-A- H0 792 199
- JP-A- 2011 196 798
- US-A1- 2011 080 165
- US-A1- 2012 062 215
- US-A1- 2013 057 273

## Description

### TECHNICAL FIELD

The present invention relates to a so-called magnetic field equilibrium type current detection device which uses a feedback coil.

### BACKGROUND ART

Patent Document 1 discloses an invention regarding a so-called magnetic field equilibrium type current detection device.

In the current detection device, a conductor through which a current to be measured passes faces a magnetoresistive effect element and a feedback coil. A current magnetic field excited by the current flowing through the conductor is detected by the magnetoresistive effect element, and a feedback current corresponding to the magnitude of the detection output is applied to the feedback coil. A cancellation magnetic field in a direction opposite to the current magnetic field is applied to the magnetoresistive effect element from the feedback coil. When the current magnetic field and the cancellation magnetic field enter an equilibrium state, a voltage corresponding to the current flowing through the feedback coil is detected.

In the current detection device described in Patent Document 1, for a reduction in size, the feedback coil is formed in a planar pattern in which round loci are formed by coil lines. In the feedback coil, two portions where the coil lines extend along linear loci are provided, and one of the portions forms an element facing portion that faces the magnetoresistive effect element.

US 2013/057273 A1 discloses a current sensor which includes a magnetoresistive element and magnetic shields arranged between a current line and the magnetoresistive element. The magnetic shields include a flat first magnetic shield placed so as to attenuate the strength of an induction magnetic field applied to the magnetoresistive element and a flat second magnetic shield placed apart from the first magnetic shield in a direction in-plane with the main surface of the first magnetic shield so as to attenuate the strength of the induction magnetic field applied to the magnetoresistive element and reduce the influence of residual magnetization in the first magnetic shield.

US 2012/062215 A1 discloses a magnetic-balance-system current sensor which includes a magnetoresistive element, a resistance value of the magnetoresistive element being changed by applying an induction magnetic field generated by a measurement target current, magnetic cores disposed near the magnetoresistive element, a feedback coil disposed near the magnetoresistive element and configured to generate a cancelling magnetic field that cancels out the induction magnetic field, and a magnetic-field detecting bridge circuit having two outputs.

The present invention relates to a current detection device according to the appended claims.

### RELATED ART DOCUMENT

### PATENT DOCUMENT

[Patent Document 1] Japanese Unexamined Patent Application Publication No. 2013-53903

### DISCLOSURE OF THE INVENTION

### PROBLEMS TO BE SOLVED BY THE INVENTION

A capability of detecting the amount of current passing through the conductor by the current detection device described in Patent Document 1 is determined by the amount of current flowing through the feedback coil. That is, a high current that generates a high current magnetic field that cannot be canceled by the cancellation magnetic field induced from the feedback coil cannot be detected.

In order to form a current detection device capable of detecting a high measurement current, increasing the amount of current per unit width of the feedback coil is necessary. In order to increase the amount of current per unit width, reducing the pitch between the coil lines or reducing the width dimension of the coil line is necessary.

However, when the pitches between the coils are decreased over the entire feedback coil, the planar pattern of the coil lines has to be more precisely processed, resulting in an increase in production costs. When the width dimension of the coil line is reduced, the resistance of the feedback coil is increased, and there is a problem of an increase in power consumption.

In order to solve the problems in the related art, an obj ect of the present invention is to provide a current detection device capable of increasing a cancellation magnetic field from a feedback coil without forming the pattern of the feedback coil more precisely than necessary.

In addition, another object of the present invention is to provide a current detection device capable of increasing a cancellation magnetic field from a feedback coil and suppressing an increase in the resistance of the feedback coil.

### MEANS FOR SOLVING THE PROBLEMS

According to the present invention, a current detection device includes: a current path through which a current to be measured flows; a feedback coil; a magnetic detection element which faces both the current path and the feedback coil; a coil current-carrying portion which controls a feedback current applied to the feedback coil according to an increase or decrease in a detection output of the magnetic detection element; and a detection portion which detects an amount of current flowing through the feedback coil, in which the feedback coil is formed in a planar pattern in which a coil line is coiled into a plurality of windings, a portion of the feedback coil forms an element facing portion which faces the magnetic detection element, and an amount of current per unit width in the element facing portion is higher than an amount of current per unit width in portions other than the element facing portion.

In the current detection device of the present invention, since the amount of current per unit width in the element facing portion is high and the current density at this portion is high, a high cancellation magnetic field can therefore be applied to the magnetic detection element, and the amount of current that can be measured can be increased.

In the current detection device of the present invention, in the feedback coil, a width dimension of the coil line in the element facing portion may be smaller than a width dimension of the coil line in the portions other than the element facing portion.

In this case, it is preferable that, in the feedback coil, a pitch between the coil lines is the same between the element facing portion and the portions other than the element facing portion.

In this configuration, the width dimension of the coil line is small only in the element facing portion of the feedback coil, and the width dimensions of the portions other than the element facing portion are formed to be large. Therefore, the cancellation magnetic field can be increased without a more than necessary increase in the total resistance of the feedback coil.

In the current detection device of the present invention, in the feedback coil, a pitch between the coil lines in the element facing portion may be set to be smaller than a pitch between the coil lines in the portions other than the element facing portion.

In this configuration, the pitch between the coil lines is small only in the element facing portion of the feedback coil, and the pitches between the coil lines in the portions other than the element facing portion are large. Therefore, the cancellation magnetic field can be increased without more than necessary precision processing of the feedback coil. Therefore, a high amount of current can be detected with a relatively low cost.

In the present invention, the feedback coil includes the element facing portion in which a plurality of the coil lines linearly extend, and a parallel portion in which a plurality of the coil lines linearly extend parallel to the element facing portion, and a coil width dimension of the element facing portion is smaller than a coil width dimension of the parallel portion.

### ADVANTAGEOUS EFFECTS OF THE INVENTION

In the current detection device of the present invention, a high cancellation magnetic field can be applied to a magnetoresistive effect element without a more than necessary increase in resistance and without more than necessary precision processing, and thus a high current can be detected.

### BRIEF DESCRIPTION OF THE DRAWINGS

Fig. 1 is a plan view illustrating a current detection device of a first embodiment of the present invention.
Fig. 2 is a sectional view of the current detection device illustrated in Fig. 1, taken along line II-II.
Fig. 3A is an explanatory view illustrating magnetic detection elements provided in the current detection device illustrated in FIG. 1, and a wiring structure thereof, and Fig. 3B is an enlarged plan view illustrating each magnetic detection element.
Fig. 4 is a circuit diagram of the current detection device.
Fig. 5 is a plan view illustrating a feedback coil of a current detection device of Comparative Example 1.
Fig. 6 is a plan view illustrating a feedback coil of a current detection device of Comparative Example 2.
Fig. 7 is a plan view illustrating a feedback coil of the current detection device of the first embodiment.
Fig. 8 is a plan view illustrating a feedback coil of a current detection device of a second embodiment.
Fig. 9 is a plan view illustrating a feedback coil of a current detection device of a third embodiment.

### BEST MODE FOR CARRYING OUT THE INVENTION

### (Structure and Operation of Current Detection Device)

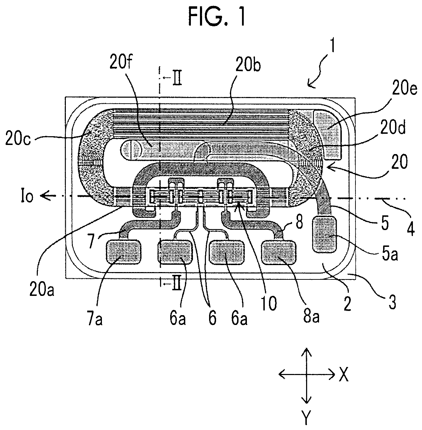

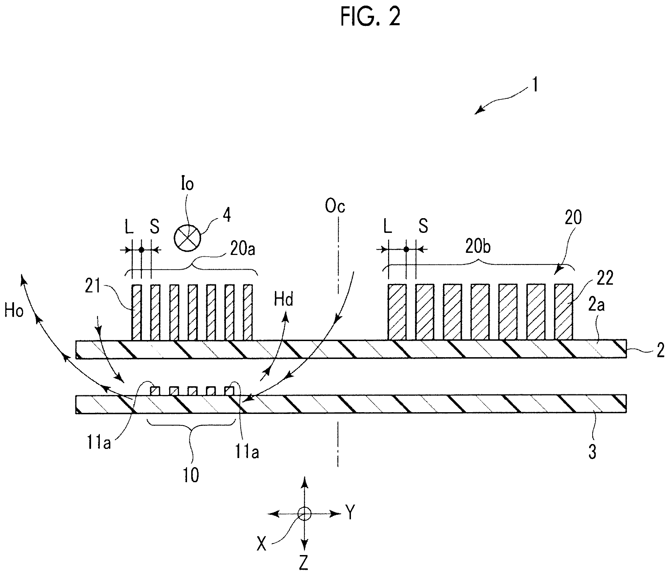

As illustrated in Fig. 2, a current detection device 1 of an embodiment of the present invention includes a coil substrate 2, and an element substrate 3 provided therebelow. A current path 4 is disposed above the coil substrate 2. As illustrated in Fig. 1, the current path 4 linearly extends in an X direction, and current 10 to be measured passes through the inside of the current path 4.

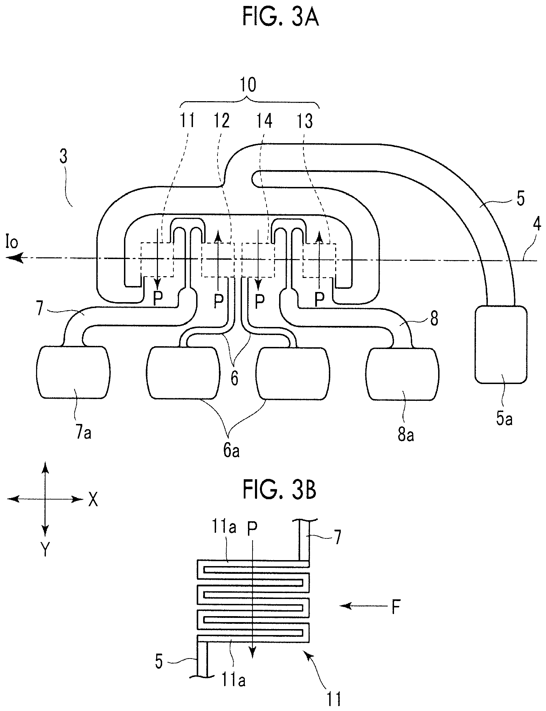

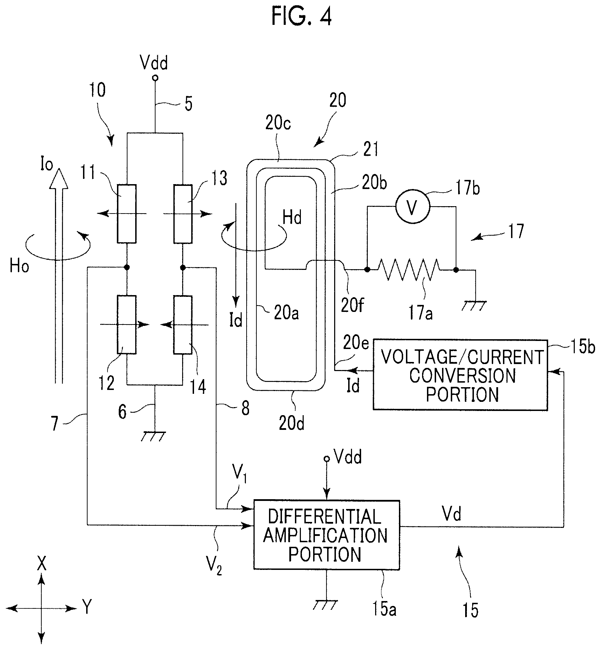

As illustrated in Fig. 3A, a magnetic detection element 10 and wiring paths 5, 6, 7, and 8 are formed on the surface of the element substrate 3. The magnetic detection element 10 is constituted by four magnetoresistive effect elements 11, 12, 13, and 14. As also shown in a circuit diagram of Fig. 4, the wiring path 5 is connected to the magnetoresistive effect elements 11 and 13, and a connection land portion 5a is formed at the terminal portion of the wiring path 5. The magnetoresistive effect elements 11 and 12 are connected in series, and the magnetoresistive effect elements 13 and 14 are connected in series. The wiring paths 6 are respectively connected to the magnetoresistive effect elements 12 and 14, and connection land portions 6a are respectively formed at the terminal end portions of the wiring paths 6.

The wiring path 7 is connected to the midpoint between the magnetoresistive effect elements 11 and 12 connected in series, and the wiring path 8 is connected to the midpoint between the magnetoresistive effect elements 13 and 14 connected in series. A connection land portion 7a is formed at the terminal portion of the wiring path 7, and a connection land portion 8a is formed at the terminal portion of the wiring path 8.

The plane shape of the magnetoresistive effect element 11 is shown in Fig. 3B. The other magnetoresistive effect elements 12, 13, and 14 are the same as the magnetoresistive effect element 11 in the planar pattern and the laminated structure.

As illustrated in Fig. 3B, the magnetoresistive effect element 11 is formed in a so-called meandering shape such that element units 11a, in which the longitudinal dimension in the X direction is larger than the width dimension in a Y direction, are formed parallel to each other and the end portions of the element units 11a on the X direction side are alternately connected.

An insulating base layer is formed on the surface of the element substrate 3 formed as a silicon substrate or the like, and multiple metallic layers are laminated thereon, thereby forming the element unit 11a. The metallic layers forming the element unit 11a are formed by a sputtering process or a CVD process.

The element unit 11a is a giant magnetoresistive effect element layer (GMR layer) which exhibits giant magnetoresistance. A fixed magnetic layer, a non-magnetic layer, and a free magnetic layer are sequentially laminated on the insulating baser layer, and the surface of the free magnetic layer is covered with a protective layer.

The fixed magnetic layer has a laminated ferrimagnetic structure in which a non-magnetic intermediate layer is interposed between a first fixed layer and a second fixed layer. The first and second fixed layers are formed of a soft magnetic material such as a CoFe alloy (cobalt-iron alloy), and the non-magnetic intermediate layer is formed of Ru (ruthenium) or the like. The fixed magnetic layer having the laminated ferrimagnetic structure is a so-called self-pinned structure in which the magnetization directions of the first and second fixed layers are fixed antiparallel to each other. In Figs. 3A and 3B, the magnetization fixed layer of the second fixed layer which is in contact with the non-magnetic layer is indicated by P. The magnetization fixed layer P is the sensitivity axis direction of each of the element units 11a. As illustrated in Fig. 4A, the fixed directions P of the magnetoresistive effect elements 11 and 14 are the same, and the fixed directions P of the magnetoresistive effect elements 12 and 13 are the same.

The non-magnetic layer is formed of a non-magnetic material such as Cu (copper) . The free magnetic layer is formed of a soft magnetic material such as an NiFe alloy (nickel-iron alloy). In the free magnetic layer, the longitudinal dimension in a longitudinal direction (X direction) is sufficiently larger than the width dimension in a transverse direction (Y direction), and due to its shape anisotropy, the magnetization direction thereof is aligned with an F direction parallel to the X direction. The protective layer that covers the free magnetic layer is formed of Ta (tantalum).

When an external magnetic field directed toward the Y direction from the outside is applied to the element units 11a, the magnetization direction aligned with the F direction in the free magnetic layer is inclined toward the Y direction. As the angle between the vector of the magnetization direction of the free magnetic layer and vector P of the fixed magnetization direction decreases, the electrical resistance of the element unit 11a decreases. As the angle between the vector of the magnetization direction of the free magnetic layer and the vector P of the fixed magnetization direction increases, the resistance of the element unit 11a increases.

As illustrated in the circuit diagram of Fig. 4, a power source Vdd is connected to the wiring path 5, the wiring paths 6 and 6 are set to the ground potential, and a constant voltage is applied to a bridge circuit constituted by the magnetoresistive effect elements 11, 12, 13, and 14. A midpoint voltage V1 is obtained from the wiring path 8, and a midpoint potential V2 is obtained from the wiring path 7.

As illustrated in Fig. 2, the upper surface of the coil substrate 2 is a coil support surface 2a, and a feedback coil 20 is disposed on the coil support surface 2a. As illustrated in Figs. 1 and 2, the feedback coil 20 is formed to have a planar pattern on the coil support surface 2a and is formed into a plurality of windings around a winding axis Oc that vertically extends from the coil support surface 2a.

In addition, in Fig. 2, the coil substrate 2 and the element substrate 3 are formed separately from each other. However, by forming the coil substrate 2 as a silicon oxide film or the like, the element substrate 3, the magnetoresistive effect elements 11, 12, 13, and 14, the coil substrate 2, and the feedback coil 20 may be continuously formed as thin films via insulating layers or the like as necessary and the layers may be integrally formed.

Coil lines 21 forming the feedback coil 20 are formed through gold plating. As a production method thereof, a conductive base film is formed on the surface of the coil support substrate 2 through sputtering. A resist layer is formed thereon, and only portions of the resist layer corresponding to the pattern of the coil lines are removed through exposure and development. Layers of gold are allowed to grow in grooves from which the resist layer is removed through plating. Thereafter, the resist layer is removed, and portions of the base layer covered with the resist layer are removed through milling.

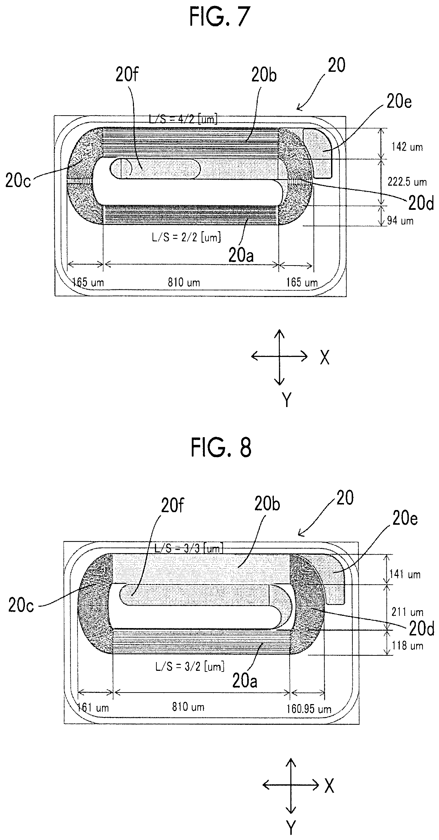

Fig. 7 illustrates a plan view of only the feedback coil 20 provided in the current detection device 1 of a first embodiment illustrated in Fig. 1. The feedback coil 20 includes an element facing portion 20a in which the coil lines 21 linearly extend parallel to each other in the X direction, and a parallel portion 20b in which the coil lines 21 linearly extend parallel to each other in the X direction at a position distant from the element facing portion 20a in the Y direction. The element facing portion 20a and the parallel portion 20b are connected to round portions 20c and 20d positioned on both sides in the X direction.

As illustrated in the circuit diagram of Fig. 4, in the feedback coil 20, the coil line 21 connected to one current pad 20e is coiled to pass through the parallel portion 20b, the round portion 20c, the element facing portion 20a, the round portion 20d, the parallel portion 20b, the round portion 20c, the element facing portion 20a, and the round portion 20d in this order, and for example, in a state where the coil line 21 is wound into about 24 turns, the terminal of the coil line 21 is connected to a current pad 20f.

As illustrated in Fig. 2, the element facing portion 20a of the feedback coil 20 faces both the current path 4 and the magnetic detection element 10.

In Fig. 2, the width dimension of the coil line 21 in the Y direction is denoted by L, and the dimension of the gap between the adjacent coil lines 21 in the Y direction is denoted by S. In the current detection device 1 of the first embodiment, as illustrated in Fig. 2, the width dimension of the coil line 21 of the feedback coil 20 is larger in the element facing portion 20a than in the parallel portion 20b, and the gap dimensions S of the coil lines 21 (the pitches in the Y direction) are the same between the element facing portion 20a and the parallel portion 20b. In the round portion 20c, the width dimension of the coil line 21 gradually decreases from the parallel portion 20b toward the element facing portion 20a, and in the round portion 20d, the width dimension of the coil line 21 gradually increases from the element facing portion 20a toward the parallel portion 20b.

As a result, the width dimension in the Y direction of the element facing portion 20a of the feedback coil 20 is smaller than the width dimension in the Y direction of the parallel portion 20b.

As illustrated in the circuit section of Fig. 4, the midpoint voltage V1 obtained in the wiring path 8 and the midpoint potential V2 obtained in the wiring path 7 may be applied to a coil current-carrying portion 15. The coil current-carrying portion 15 includes a differential amplification portion 15a, and a voltage/current conversion portion 15b. The differential amplification portion 15a is configured to include an operational amplifier as the main member and generates a compensation voltage Vd for causing the difference between the input midpoint voltages V1 and V2 (V1 - V2) to become zero. The compensation voltage Vd is converted into a compensation current Id by the voltage/current conversion portion 15b, and the compensation current Id may be applied to the feedback coil 20 as a cancellation current.

When the midpoint potentials V1 and V2 input to the differential amplification portion 15a are the same, the difference (V1 - V2) therebetween is zero, and thus the compensation voltage Vd is zero. When there is a difference between the midpoint potentials V1 and V2 input to the differential amplification portion 15a, a compensation voltage Vd for causing the difference to become zero is generated. When the potential difference (V1 - V2) thereafter decreases, the rate of increase in the compensation voltage Vd decreases, and the compensation voltage Vd is stabilized as a constant value at a point of time when the potential difference (V1 - V2) becomes zero.

When the voltage difference (V1 - V2) input to the coil current-carrying portion 15 is high, the compensation voltage Vd increases, and a high compensation current Id flows through the feedback coil 20. When the voltage difference (V1 - V2) input to the coil current-carrying portion 15 is low, the compensation voltage Vd decreases, and a low compensation current Id flows through the feedback coil 20. In either case, at a point of time when the voltage difference (V1 - V2) thereafter becomes zero, the compensation voltage Vd becomes a constant voltage and the compensation current Id is stabilized. As the voltage difference (V1 - V2) at the input point of time increases, the stabilized compensation voltage Vd increases, and the amount of the compensation current Id increases.

The differential amplification portion 15a and the voltage/current conversion portion 15b, which are integrated with each other, may also be called a compensation type differential amplification portion. This differential amplification portion outputs a compensation current Id for causing the input voltage difference (V1 - V2) to become zero.

As illustrated in Fig. 4, a current detection portion 17 is connected to the current pad 20f of the feedback coil 20. The current detection portion 17 includes a resistor 17a connected to the coil line 21 in series, and a voltage detection portion 17b which detects a voltage applied to the resistor 17a.

Next, an operation of the current detection device 1 will be described.

As illustrated in Figs. 2 and 4, a current magnetic field H0 may be induced by the measurement current 10 passing through the current path 4 in the X direction, and the current magnetic field H0 is applied to the magnetic detection element 10. The current magnetic field H0 acts to decrease the resistances of the magnetoresistive effect elements 11 and 14 and acts to increase the resistances of the magnetoresistive effect elements 12 and 13. Therefore, the midpoint voltage V1 obtained in the wiring path 8 increases, and the midpoint potential V2 obtained in the wiring path 7 decreases.

When the midpoint voltage V1 and the midpoint potential V2 are applied to the coil current-carrying portion 15, in the coil current-carrying portion 15, a compensation current Id for causing the potential difference (V1 - V2) between the midpoint potentials to become zero is generated, and the compensation current Id is applied to the feedback coil 20 as a cancellation current. As illustrated in Fig. 4, in the feedback coil 20, the compensation current Id that flows through the element facing portion 20a is in a direction opposite to the measurement current 10 flowing through the current path 4, and the direction of the cancellation magnetic field Hd induced by the element facing portion 20a is opposite to the direction of the current magnetic field H0.

As illustrated in Fig. 2, the cancellation magnetic field Hd in the direction opposite to the current magnetic field H0 is applied to the magnetic detection element 10. Therefore, at a point of time when the potential difference (V1 - V2) between the midpoint potential V1 and the midpoint potential V2 illustrated in Fig. 4 becomes zero, the compensation current Id is stabilized and enters an equilibrium state. A current flowing through the feedback coil 20 is detected by the detection portion 17 illustrated in Fig. 4, and this becomes a current measurement value of the measurement current I0.

### (Feedback Coil in First Embodiment)

One of conditions for determining a capability of measuring a certain degree of magnitude of the measurement value 10 that can be measured by the current detection device 1 is that which degree of magnitude of the cancellation magnetic field Hd can be applied to the magnetic detection element 10 by the element facing portion 20a of the feedback coil 20. Since the amount of current is detected by the detection portion 17 when the current magnetic field H0 and the cancellation magnetic field Hd applied to the magnetic detection element 10 enter an equilibrium state, in order to increase the measurement capability of the current detection device 1, there is a need to apply a high cancellation magnetic field Hd to the magnetic detection element 10 from the element facing portion 20a of the feedback coil 20. For this, increasing the amount of current per unit width in the element facing portion 20a in the Y direction, that is, increasing a current density is necessary.

Here, in the current detection device 1 of the first embodiment, as illustrated in Fig. 2, the width dimension L of the coil line 21 in the element facing portion 20a is smaller than the width dimension L of the coil line 21 in the parallel portion 20b. By decreasing the width dimension L of the coil line 21 in the element facing portion 20a, the amount of current per unit width in the Y direction can be increased, and thus a high cancellation magnetic field Hd can be applied to the magnetic detection element 10 from the element facing portion 20a.

On the other hand, in the parallel portion 20b other than the element facing portion 20a, the width dimension L of the coil line 21 is large, and the average width dimension of the coil line 21 in the round portions 20c and 20d is larger than that of the element facing portion 20a. Therefore, the DC resistance of the entirety of the feedback coil 20 (the average of DC resistances) can be prevented from increasing more than necessary, and power consumption can be reduced.

In addition, as illustrated in Fig. 2, since the gap dimensions S between the coil lines 21 in the Y direction are the same between the element facing portion 20a and the parallel portion 20b (same pitch), the element facing portion 20a and the parallel portion 20b can be formed with the same processing precision.

### (Feedback Coils of Second and Third Embodiments)

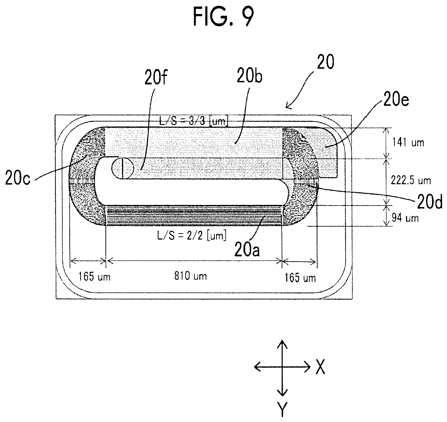

Fig. 8 illustrates the feedback coil 20 used in the current detection device 1 of a second embodiment, and Fig. 9 illustrates the feedback coil 20 used in the current detection device 1 of a third embodiment.

In the feedback coil 20 illustrated in Fig. 8, the width dimensions L of the coil lines 21 are the same between all of the element facing portion 20a, the parallel portion 20b, and the round portions 20c and 20d. Here, only in the element facing portion 20a, the pitch, that is, gap dimension S between the adjacent coil lines 21 in the Y direction is small.

Even in the second embodiment, the amount of current per unit width dimension in the Y direction in the element facing portion 20a is increased, and a high cancellation magnetic field Hd can be applied to the magnetic detection element 10. Here, in the parallel portion 20b and the round portions 20c and 20d other than the element facing portion 20a, the gap dimension S of the coil lines 21 is large, and there is no need to perform more than necessary precision processing on the entire feedback coil 20, and an excessive in increase in total production costs can be avoided.

In the feedback coil 20 illustrated in Fig. 9, both the width dimension L and the gap dimension S of the coil line 21 in the element facing portion 20a are smaller than those of the parallel portion 20b. In this structure, the amount of current per width dimension in the Y direction in the element facing portion 20a can be significantly increased, and a high cancellation magnetic field Hd can be applied to the magnetic detection element 10. Accordingly, the measurement capability of the current detection device 1 can be further increased.

In portions of the feedback coil 20 other than the element facing portion 20a, the width dimension L and the gap dimension S of the coil line 21 can be increased. Therefore, an increase in the total resistances can be suppressed, and more than necessary precision processing can be voided.

### (Comparison between Comparative Example and Embodiment)

Hereinafter, simulation results of the current detection device 1 which uses feedback coils of comparative examples and the embodiments will be described.

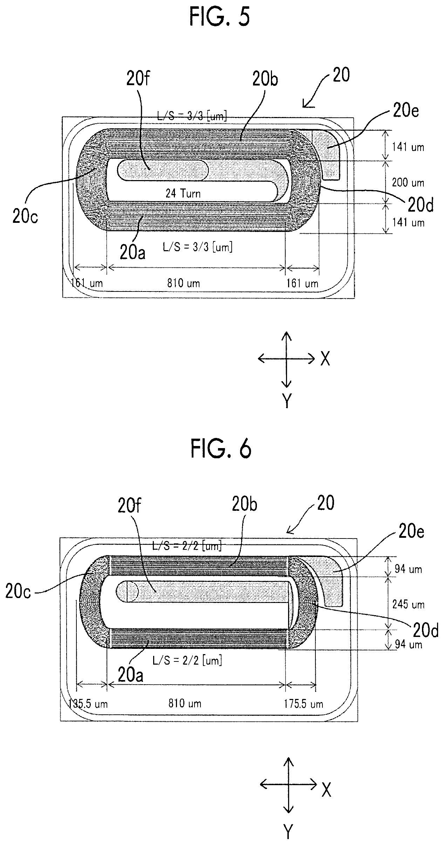

Figs. 5 and 6 illustrate the feedback coils 20 used in the current detection device 1 of the comparative examples. In the feedback coil 20 of Comparative Example 1 illustrated in Fig. 5, the width dimensions L and the gap dimensions S of the coil lines 21 are the same between all the element facing portion 20a, the parallel portion 20b, and the round portions 20c and 20d.

In the feedback coil 20 of Comparative Example 2 illustrated in Fig. 6, the width dimensions L and the gap dimensions S are the same between all the element facing portion 20a, the parallel portion 20b, and the round portions 20c and 20d. However, the width dimensions L and the gap dimensions S of the coil lines 21 are formed to be smaller than those of Comparative Example 1 of Fig. 5.

Figs. 5 to 9 respectively show the dimensions of each portion of the simulated feedback coil 20 in Comparative Example 1, Comparative Example 2, the first embodiment, the second embodiment, and the third embodiment. The width dimension L and the gap dimension S of the coil line 21 in the element facing portion 20a and the width dimension L and the gap dimension S of the coil line 21 in the parallel portion 20b are shown. The unit of the dimensions illustrated in each of the figures is "µm".

As shown in Table 1 below, in Comparative Example 1 illustrated in Fig. 5, both the width dimensions L and the gap dimensions S of the coil lines 21 in the element facing portion 20a and the parallel portion 20b are 3 µm. In Comparative Example 2 illustrated in Fig. 6, the width dimensions L and the gap dimensions S of the coil lines 21 in the element facing portion 20a and the parallel portion 20b are 2 µm.

In the first embodiment illustrated in Fig. 7, while the gaps S between the coil lines 21 in both the element facing portion 20a and the parallel portion 20b are 2 µm, the width dimension L is 2 µm in the element facing portion 20a and is 4 µm in the parallel portion 20b.

In the second embodiment illustrated in Fig. 8, the gap S is 2 µm in the element facing portion 20a and is 3 µm in the parallel portion 20b, and the width dimensions L in both the element facing portion 20a and the parallel portion 20b are 3 µm.

In the third embodiment illustrated in Fig. 9, both the width dimension L and the gap dimension S in the element facing portion 20a are 2 µm, and both the gap S and the width dimension L in the parallel portion 20b are 3 µm.

In Table 1 below, for comparison between Comparative Example 1 and the embodiments, the magnitudes of the cancellation magnetic fields Hd induced by the element facing portion 20a when a current applied to a coil is 10 mA, and the rate of increase in each of the cancellation magnetic fields Hd with respect to Comparative Example 1 as 100% is shown. In addition, coil resistances and the rate of increase in the coil resistance when the coil resistance in Comparative Example 1 is assumed to be 100% is shown.

**[Table 1]**

| Coil L/S [µm] | Coil L/S [µm] | | Cancellation magnetic field [mT] when coil current is 10 mA | Rate of increase in cancellation magnetic field | Coil resistance [Ω] | Rate of increase in resistance from Comparative Example 1 | Fig No. |
|---|---|---|---|---|---|---|---|
| | Element facing portion | Other than element facing portion | | | | | |
| Comparative Example 1 | 3/3 | 3/3 | 0.992 | 100% | 100 | 100% | Fig. 5 |
| Comparative Example 2 | 2/2 | 2/2 | 1.610 | 162% | 150 | 150% | Fig. 6 |
| First Embodiment | 2/2 | 4/2 | 1.610 | 162% | 111 | 111% | Fig. 7 |
| Second Embodiment | 3/2 | 3/3 | 1.243 | 125% | 100 | loot | Fig. 8 |
| Third Embodiment | 2/2 | 3/3 | 1.610 | 162% | 121 | 121% | Fig. 9 |

As illustrated in Table 1, in all the first, second, and third embodiments, the cancellation magnetic fields are higher than that in Comparative Example 1, and the rates of increase in the coil resistance are lower than that of Comparative Example 2.

### DESCRIPTION OF REFERENCE NUMERALS

- 1: current detection device
- 2: coil support substrate
- 3: element substrate
- 4: current path
- 10: magnetic detection element
- 11, 12, 13, 14: magnetoresistive effect element
- 11a: element unit
- 15: coil current-carrying portion
- 17: detection portion
- 20: feedback coil
- 20a: element facing portion
- 20b: parallel portion
- 20c, 20d: round portion
- 21: coil line
- H0: current magnetic field
- Hd: cancellation magnetic field
- 10: measurement current
- L: width dimension
- S: gap dimension

## Claims

1. A current detection device (1) comprising:
a current path (4) through which a current to be measured flows;
a feedback coil (20);
a magnetic detection element (10) which faces both the current path (4) and the feedback coil (20);
a coil current-carrying portion (15) adapted to control a feedback current applied to the feedback coil (20) according to an increase or decrease in a detection output of the magnetic detection element (10); and
a detection portion (17) adapted to detect an amount of current flowing through the feedback coil (20),
wherein the feedback coil (20) is formed in a planar pattern in which a coil line (21) is coiled into a plurality of windings,
a portion of the feedback coil (20) forms an element facing portion (20a) in which a plurality of the coil lines (21) face the magnetic detection element (10), and
wherein in operation, an amount of current per unit of width in the element facing portion (20a) in a direction perpendicular to the coiling direction of the coil line (21) is higher than an amount of current per unit of width in portions other than the element facing portion (20a).

2. The current detection device (1) according claim 1,
wherein the feedback coil (20) is provided with a parallel portion (20b) having the plurality of coil lines (21) extending parallel to the coil lines (21) forming the element facing portion (20a), and
the amount of current per unit of width in the element facing portion (20a) in the direction perpendicular to the coiling direction of the coil line (21) is higher than the amount of current per unit of width in the parallel portion (20b).

3. The current detection device (1) according to claim 1,
wherein, in the feedback coil (20), a width dimension (L) of the coil line (21) in the element facing portion (20a) is smaller than a width dimension of the coil line (21) in the portions other than the element facing portion (20a).

4. The current detection device (1) according to claim 3,
wherein, in the feedback coil (20), a gap dimension (S) between the coil lines (21) is the same between the element facing portion (20a) and the portions other than the element facing portion (20a).

5. The current detection device (1) according to claim 1,
wherein, in the feedback coil (20), a gap dimension (S) between the coil lines (21) in the element facing portion (20a) is set to be smaller than a gap dimension between the coil lines (21) in portions other than the element facing portion (20a).

6. The current detection device (1) according to claim 3,
wherein, in the feedback coil (20), a gap dimension (S) between the coil lines (21) in the element facing portion (20a) is set to be smaller than a gap between the coil lines (21) in the portions other than the element facing portion (20a).

## Patentansprüche

1. Stromerfassungsvorrichtung (1) aufweisend:
einen Strompfad (4), über den ein zu messender Strom fließt;
eine Rückkopplungsspule (20);
ein magnetisches Erfassungselement (10), das sowohl dem Strompfad (4) als auch der Rückkopplungsspule (20) zugewandt ist;
einen Spulenstrom führenden Bereich (15), der dazu ausgebildet ist, einen an die Rückkopplungsspule (20) angelegten Rückkopplungsstrom in Abhängigkeit von einer Zunahme oder Abnahme eines Erfassungsausgangs des magnetischen Erfassungselements (10) zu steuern; und
einen Erfassungsbereich (17), der dazu ausgebildet ist, eine durch die Rückkopplungsspule (20) fließende Strommenge zu erfassen,
wobei die Rückkopplungsspule (20) in einem planaren Muster ausgebildet ist, in dem eine Spulenleitung (21) in einer Mehrzahl von Windungen gewickelt ist,
wobei ein Bereich der Rückkopplungsspule (20) einen dem Element zugewandten Bereich (20a) bildet, in dem eine Mehrzahl der Spulenleitungen (21) dem magnetischen Erfassungselement (10) zugewandt ist, wobei im Betrieb eine Strommenge pro Breiteneinheit in dem dem Element zugewandten Bereich (20a) in einer zu der Wicklungsrichtung der Spulenleitung (21) rechtwinkligen Richtung höher ist als eine Strommenge pro Breiteneinheit in anderen Bereichen als dem dem Element zugewandten Bereich (20a).

2. Stromerfassungsvorrichtung (1) nach Anspruch 1,
wobei die Rückkopplungsspule (20) einen parallelen Bereich (20b) aufweist, in dem sich die Mehrzahl der Spulenleitungen (21) parallel zu den Spulenleitungen (21) erstrecken, die den dem Element zugewandten Bereich (20a) bilden, und
wobei die Strommenge pro Breiteneinheit in dem dem Element zugewandten Bereich (20a) in der zu der Wicklungsrichtung der Spulenleitung (21) rechtwinkligen Richtung höher ist als die Strommenge pro Breiteneinheit in dem parallelen Bereich (20b).

3. Stromerfassungsvorrichtung (1) nach Anspruch 1,
wobei in der Rückkopplungsspule (20) eine Breitenabmessung (L) der Spulenleitung (21) in dem dem Element zugewandten Bereich (20a) kleiner ist als eine Breitenabmessung der Spulenleitung (21) in den anderen Bereichen als dem dem Element zugewandten Bereich (20a).

4. Stromerfassungsvorrichtung (1) nach Anspruch 3,
wobei in der Rückkopplungsspule (20) eine Abstandsabmessung (S) zwischen den Spulenleitungen (21) zwischen dem dem Element zugewandten Bereich (20a) und den anderen Bereichen als dem dem Element zugewandten Bereich (20a) gleich ist.

5. Stromerfassungsvorrichtung (1) nach Anspruch 1,
wobei in der Rückkopplungsspule (20) eine Abstandsabmessung (S) zwischen den Spulenleitungen (21) in dem dem Element zugewandten Bereich (20a) kleiner vorgegeben ist als eine Abstandsabmessung zwischen den Spulenleitungen (21) in anderen Bereichen als dem dem Element zugewandten Bereich (20a).

6. Stromerfassungsvorrichtung (1) nach Anspruch 3,
wobei in der Rückkopplungsspule (20) eine Abstandsabmessung (S) zwischen den Spulenleitungen (21) in dem dem Element zugewandten Bereich (20a) kleiner vorgegeben ist als eine Abstandsabmessung zwischen den Spulenleitungen (21) in den anderen Bereichen als dem dem Element zugewandten Bereich (20a).

## Revendications

1. Dispositif de détection de courant (1), comprenant :
un trajet de courant (4) à travers lequel circule un courant à mesurer ;
une bobine de rétroaction (20) ;
un élément de détection magnétique (10), lequel fait face à la fois au trajet de courant (4) et à la bobine de rétroaction (20) ;
une portion de bobine porteuse de courant (15) apte à commander un courant de rétroaction appliqué à la bobine de rétroaction (20) conformément à une augmentation ou diminution dans une sortie de détection de l'élément de détection magnétique (10), et
une portion de détection (17) apte à détecter une quantité de courant circulant à travers la bobine de rétroaction (20),
dans lequel la bobine de rétroaction (20) est formée suivant un motif planaire où une ligne de bobine (21) est enroulée en une pluralité d'enroulements ;
une portion de la bobine de rétroaction (20) forme une portion faisant face à l'élément (20a) où une pluralité de lignes de bobine (21) font face à l'élément de détection magnétique (10), et
dans lequel, en fonctionnement, une quantité de courant par unité de largeur dans la portion faisant face à l'élément (20a) dans une direction perpendiculaire à la direction d'enroulement de la ligne de bobine (21) est supérieure à une quantité de courant par unité de largeur dans des portions autres que la portion faisant face à l'élément (20a).

2. Dispositif de détection de courant (1) selon la revendication 1,
dans lequel la bobine de rétroaction (20) est dotée d'une portion parallèle (20b) présentant la pluralité de lignes de bobine (21) s'étendant parallèlement aux lignes de bobine (21) formant la portion faisant face à l'élément (20a), et
la quantité de courant par unité de largeur dans la portion faisant face à l'élément (20a) dans la direction perpendiculaire à la direction d'enroulement de la ligne de bobine (21) est supérieure à la quantité de courant par unité de largeur dans la portion parallèle (20b).

3. Dispositif de détection de courant (1) selon la revendication 1,
dans lequel dans la bobine de rétroaction (20), une dimension de largeur (L) de la ligne de bobine (21) dans la portion faisant face à l'élément (20a) est inférieure à une dimension de largeur de la ligne de bobine (21) dans les portions autres que la portion faisant face à l'élément (20a).

4. Dispositif de détection de courant (1) selon la revendication 3,
dans lequel dans la bobine de rétroaction (20), une dimension d'espace (S) entre les lignes de bobine (21) est identique entre la portion faisant face à l'élément (20a) et les portions autres que la portion faisant face à l'élément (20a).

5. Dispositif de détection de courant (1) selon la revendication 1,
dans lequel dans la bobine de rétroaction (20), une dimension d'espace (S) entre les lignes de bobine (21) dans la portion faisant face à l'élément (20a) est réglée de manière à être inférieure à une dimension d'espace entre les lignes de bobine (21) dans des portions autres que la portion faisant face à l'élément (20a).

6. Dispositif de détection de courant (1) selon la revendication 3,
dans lequel dans la bobine de rétroaction (20), une dimension d'espace (S) entre les lignes de bobine (21) dans la portion faisant face à l'élément (20a) est réglée de manière à être inférieure à un espace entre les lignes de bobine (21) dans des portions autres que la portion faisant face à l'élément (20a).
